# EUROPÄISCHE PATENTSCHRIFT

(11) **EP 2 929 627 B1**
(45) Veröffentlichungstag und Bekanntmachung des Hinweises auf die Patenterteilung: **28.09.2016**
(21) Anmeldenummer: 13702784.3
(22) Anmeldetag: 29.01.2013
(51) Int. Cl.: H03K 17/00

(54) **GLEICHSPANNUNGSSCHALTER ZUM SCHALTEN EINER KURZUNTERBRECHUNG**
DC VOLTAGE SWITCH FOR SWITCHING A SHORT INTERRUPTION
INTERRUPTEUR POUR TENSION CONTINUE POUR PRODUIRE UNE COURTE INTERRUPTION

(43) Veröffentlichungstag der Anmeldung: 14.10.2015
(73) Patentinhaber: Siemens Aktiengesellschaft, 80333 München (DE)
(72) Erfinder: ERGIN, Dominik, 91083 Baiersdorf (DE); KNAAK, Hans-Joachim, 91054 Erlangen (DE)
(86) Internationale Anmeldenummer: PCT/EP2013/051642
(87) Internationale Veröffentlichungsnummer: WO 2014/117807

(56) Entgegenhaltungen:
- EP-A1- 1 538 645
- DE-A1-102007 042 903
- DE-U1-202012 100 024

## Beschreibung

Die Erfindung betrifft eine Vorrichtung zum Schalten von Gleichströmen in einem Pol eines Gleichspannungsnetzes mit zwei Anschlussklemmen zum seriellen Einbinden der Vorrichtung in den Pol, einem sich zwischen den Anschlussklemmen erstreckenden Betriebsstrompfad, in dem ein mechanischer Schalter angeordnet ist, einem den mechanischen Schalter überbrückenden Kondensatorpfad, in dem ein Kondensator angeordnet ist, und einem in Reihe zum Kondensator angeordneten Pulsleistungshalbleiterschalter zur Entladung des Kondensators, so dass in einer aus Betriebsstrompfad und Kondensatorpfad gebildeten Masche ein dem Betriebsstrom in dem mechanischen Schalter entgegen gerichteter Impulskreisstrom fließt.

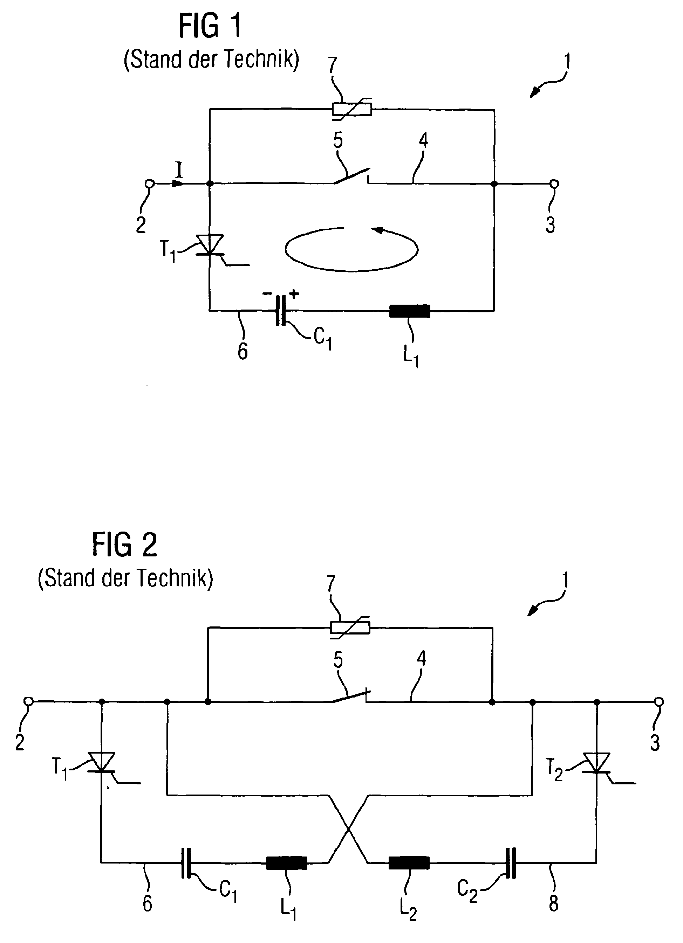

Eine solche Vorrichtung ist bereits bekannt und beispielhaft in Figur 1 als Stand der Technik gezeigt. Die dort schematisch verdeutlichte Vorrichtung 1 weist zwei Anschlussklemmen 2 und 3 auf, mit denen die Vorrichtung 1 seriell in einen figürlich nicht dargestellten Pol eines Gleichspannungsnetzes eingefügt werden kann. Zwischen den besagten Anschlussklemmen 2 und 3 erstreckt sich ein Betriebsstrompfad 4, in dem ein mechanischer Schalter 5 angeordnet ist. Ferner ist ein den mechanischen Schalter 5 überbrückender Kondensatorpfad 6 vorgesehen, in dem ein Kondensator C₁ angeordnet ist. In Reihe zum Kondensator C₁ ist ein Pulsleistungshalbleiterschalter T₁ in dem Kondensatorpfad 6 erkennbar. Darüber hinaus verfügt der Kondensatorpfad 6 über eine Induktivität L₁, ebenfalls in Reihe zum Kondensator C₁. Parallel zum Betriebsstrompfad beziehungsweise parallel zum mechanischen Schalter 5 ist ein Überspannungsableiter 7 geschaltet. Bei der in Figur 1 gezeigten Vorrichtung 1 handelt es sich um eine so genannte unidirektionale Variante, welche Ströme I in der in der Figur eingezeichneten Richtungen abschalten kann. Hierzu wird von dem durch den Pulsleistungshalbleiterschalter T₁, den Kondensator C₁ und die Induktivität L₁ gebildeten Pulsgenerator ein Stromimpuls durch Zünden des Thyristors T₁ erzeugt. Durch das Zünden wird der Thyristor T₁ leitend, so dass sich der Kondensator C₁ entlädt. Hierbei wird in einer aus dem Kondensatorpfad 6 sowie dem Betriebsstrompfad 4 gebildeten Masche ein Kreisstrom erzeugt, der dem Betriebsstrom I im mechanischen Schalter 5 entgegengesetzt ist. Im Zeitpunkt der Zündung des Thyristors T₁ und der Entladung des Kondensators C₁ ist der mechanische Schalter 5 bereits geöffnet, so dass durch den in Figur 1 eingezeichneten Impulskreisstrom der von den Kontakten des mechanischen Schalters gezogene Lichtbogen gelöscht werden kann. Der Impulskreisstrom fließt über den Thyristor T₁ und lädt den Kondensator C₁ mit entgegengesetzter Polarität auf, bis die Ansprechspannung des Ableiters 7 oder Varistors erreicht ist. Ab diesem Zeitpunkt fließt der Strom nur noch über den Ableiter 7, welcher eine Abschaltgegenspannung aufbaut, die den Betriebsgleichstrom I schließlich abschaltet. Nach diesem Schaltvorgang ist der Kondensator C₁ mit einer bezüglich der in Figur 1 gezeigten inversen Polarität aufgeladen, wodurch es nicht möglich ist, bereits nach kurzer Zeit einen erneuten Schaltvorgang durchzuführen.

Figur 2 zeigt eine ebenfalls bekannte bidirektionale Variante der Vorrichtung, bei der ein zweiter Kondensatorpfad 8 mit einem zweiten Thyristor T₂, einem zweiten Kondensator C₂ sowie einer zweiten Induktivität L₂ vorgesehen sind. Fließt der zu schaltende Strom von Anschlussklemme 3 zur Anschlussklemme 2, dient der im zweiten Kondensatorpfad 8 angeordnete Pulsgenerator mit seinen Komponenten T₂, C₂ und L₂ zum Erzeugen eines Gegenstroms im mechanischen Schalter 5. Auch bei der bidirektionalen Vorrichtung 1 gemäß Figur 2 ist ein erneuter Schaltvorgang bereits nach kurzer Zeit nicht möglich.

Aufgabe der Erfindung ist es daher, eine Vorrichtung der eingangs genannten Art zu schaffen, mit der bereits nach kurzer Zeit ein erneuter Schaltvorgang durchgeführt werden kann.

Die Erfindung löst diese Aufgabe dadurch, dass ein den Kondensator überbrückender Umpolungszweig vorgesehen ist, in dem ein ansteuerbarer Umpolungsleistungshalbleiterschalter angeordnet ist, wobei der Umpolungsleistungshalbleiterschalter so orientiert ist, dass eine Umpolung des Kondensators ermöglicht ist.

Die Erfindung basiert auf der Idee, dass die Energie für einen zweiten Abschaltvorgang bereits in der Schaltung enthalten ist. Durch das Hinzufügen eines zweckmäßig orientierten Umpolungsleistungshalbleiterschalters, mit dem der Kondensator des Kondensatorzweiges überbrückt werden kann, kann der Kondensator auf die gewünschte Polarität umschwingen. Die Voraussetzung hierfür ist jedoch, dass der Pulsleistungshalbleiterschalter im Zeitpunkt der Zündung des Umpolungsleistungshalbleiterschalters sich in seiner Sperrstellung befindet, in der ein Stromfluss über den Pulsleistungshalbleiterschalter unterbrochen ist. Da bei jedem Abschaltvorgang der Kondensator C₁ vom Leitungsstrom I bis auf die Begrenzungsspannung des Ableiters 7 aufgeladen wird, sind im Rahmen der Erfindung theoretisch unendlich viele solcher Schalthandlungen hintereinander möglich.

Vorteilhafterweise ist in dem Kondensatorpfad eine erste Induktivität L₁ angeordnet. Durch die Anordnung der ersten Induktivität L₁ im Kondensatorpfad wird der Stromanstieg (di/dt) beim Zünden des Kondensators C₁ begrenzt. Eine Schädigung des dem Schalter parallel geschalteten Ableiters ist somit weitestgehend vermieden.

Gemäß einer diesbezüglich zweckmäßigen Weiterentwicklung ist in dem Umpolungszweig eine zweite Induktivität L_{Z1} in Reihe zum Umpolungsleistungshalbleiterschalter angeordnet. Da der Kondensator C₁ nach dem ersten Abschaltvorgang auf die Begrenzungsspannung des Ableiters aufgeladen ist, besteht die Möglichkeit, dass die erste Induktivität L₁, die in dem Kondensatorzweig angeordnet ist, nicht ausreichend ist, um den Stromanstieg auf ein ausreichendes Maß zu beschränken, so dass Beschädigungen an Komponenten der erfindungsgemäßen Vorrichtung 1 vermieden sind. Aus diesem Grunde ist in dem Umpolungszweig eine zweite Induktivität L_{Z2} vorgesehen.

Will man erreichen, dass der Kondensator C₁ nach dem Umladevorgang auf seine Nennspannung aufgeladen ist und nicht auf die Begrenzungsspannung des Ableiters 7, muss der Vorrichtung Energie entzogen werden. Zu diesem Zweck kann es sinnvoll sein, einen zusätzlichen ohmschen Widerstand R_{Z1} in dem Umpolungszweig in Reihe zum Umpolungsleistungshalbleiterschalter und gegebenenfalls in Reihe zur zweiten Induktivität L_{Z1} anzuordnen.

Zweckmäßigerweise ist der Kondensatorpfad über einen Ladungswiderstand R_{V} mit dem Erdpotenzial oder einem Pol des Gleichspannungsnetzes verbindbar. Der ohmsche Ladungswiderstand R_{V} weist einen ausreichend hohen ohmschen Widerstand auf, so dass er auch während des Betriebs an dem Kondensatorzweig angeschlossen bleiben kann und die Verluste möglichst gering sind. Ein sinnvoller Wert liegt beispielsweise zwischen 400 und 600 kΩ. Abweichend hiervon ist ein mechanischer Schalter zum Verbinden mit dem Kondensatorpfad vorgesehen.

Zweckmäßigerweise ist ein zweiter Kondensatorzweig mit einem zweiten Kondensator C₂ und einem zweiten Pulsleistungshalbleiterschalter T₂ vorgesehen, wobei ein zweiter Umpolungszweig mit einem zweiten Umpolungsleistungshalbleiterschalter T_{Z2} vorgesehen ist. Gemäß dieser vorteilhaften Weiterentwicklung ist eine bidirektionale Schaltung bereitgestellt.

Gemäß zweckmäßiger Weiterentwicklung der Erfindung ist dem oder jedem mechanischen Schalter des Betriebsstromzweiges eine Entlastungsdiode parallel geschaltet. Die dem Schalter parallel geschaltete Entlastungsdiode kann den mechanischen Schalter bei der Verfestigung seiner Isolationsstrecke entlasten. Aufgrund dieser Entlastungsdiode kann sich die Isolationsstrecke im mechanischen Schalter sicher verfestigen und der mechanische Schalter anschließend problemlos die Spannung aufnehmen.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figuren 1 und 2: eine Vorrichtung gemäß dem Stand der Technik und
- Figuren 3 bis 7: Ausführungsbeispiele der erfindungsgemäßen Vorrichtung verdeutlichen.

Die Figuren 1 und 2 wurden bereits als Vorrichtungen 1 gemäß dem Stand der Technik in der Beschreibungseinleitung gewürdigt.

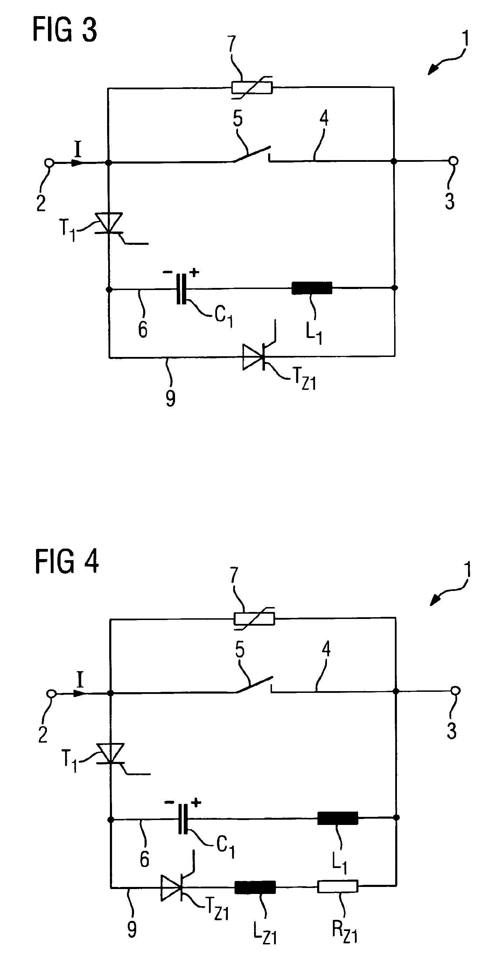

Figur 3 zeigt ein Ausführungsbeispiel der erfindungsgemäßen Vorrichtung 1, die wieder zwei Anschlussklemmen 2 und 3 aufweist, mit denen die Vorrichtung 1 seriell in einen Pol eines Gleichspannungsschalters eingefügt werden kann. Zwischen den Anschlussklemmen 2 und 3 erstreckt sich ein Betriebsstrompfad 4, in dem ein mechanischer Schalter 5 angeordnet ist. Der Schalter 5, beispielsweise ein schnell schaltender Vakuumschalter, wird von einem Kondensatorpfad 6 überbrückt, in dem ein Kondensator C₁ und in Reihe dazu eine Induktivität L₁ in Gestalt einer Spul oder Drossel angeordnet ist. In Reihe zum Kondensator C₁ ist ein Thyristor T₁ als Pulsleistungshalbleiterschalter angeordnet. In Parallelschaltung zur Reihenschaltung aus Kondensator C₁ und Induktivität L₁ ist ein Umpolungsleistungshalbleiterschalter T_{Z1} angeordnet, der hier als Thyristor ausgestaltet ist. Durch den Umpolungszweig 9 ist der Kondensator C₁ überbrückbar. Wieder parallel zum mechanischen Schalter 5 ist ein Ableiter 7 geschaltet. Wie bereits eingangs erläutert wurde, bilden der Thyristor T₁, der Kondensator C₁ und die Induktivität L₁ einen Pulsgenerator aus. Durch Zünden des Thyristors T₁ wird der Kondensator C₁ entladen und erzeugt einen Stromimpuls, so dass in der aus Betriebsstrompfad 4 und Kondensatorzweig 6 gebildeten Masche ein Impulskreisstrom erzeugt wird, der dem Betriebsstrom I im Schalter 5 entgegengerichtet ist. Ein durch die Kontakte des mechanischen Schalters 5 gezogener Lichtbogen kann so gelöscht werden. Der über den Thyristor T₁ fließende Impulskreisstrom führt schließlich zu einer Aufladung des Kondensators C₁ mit entgegengesetzter Polarität, bis die Ansprechspannung des Ableiters 7 erreicht ist. Die Induktivität L₁ dient zur Begrenzung des Stromanstieges bei der Entladung des Kondensators C₁. Um möglichst schnell erneut schalten zu können, wird der Kondensator C₁ im Rahmen der Erfindung umgepolt. Hierzu wird nach dem der Pulsleistungshalbleiterschalter T₁ seine Sperrstellung erreicht hat, der Umpolungsleistungshalbleiter T_{Z1} gezündet. Hieraufhin kommt es zur Umpolung des Kondensators C₁, so dass dieser wieder die in Figur 3 gezeigte Polarität aufweist. Anschließend kann eine erneute Schalthandlung durchgeführt werden.

Figur 4 unterscheidet sich von dem in Figur 3 gezeigten Ausführungsbeispiel dadurch, dass in dem Umpolungszweig 9 eine zweite Induktivität L_{Z1} sowie ein ohmscher Widerstand R_{Z1} angeordnet sind. Diese dienen zur Begrenzung der Stromanstiegsgeschwindigkeit sowie dazu, den Kondensator C₁ lediglich auf die Nennspannung, also die Netzspannung, aufzuladen, wobei die überflüssige Energie an dem ohmschen Widerstand R_{Z1} abgebaut wird.

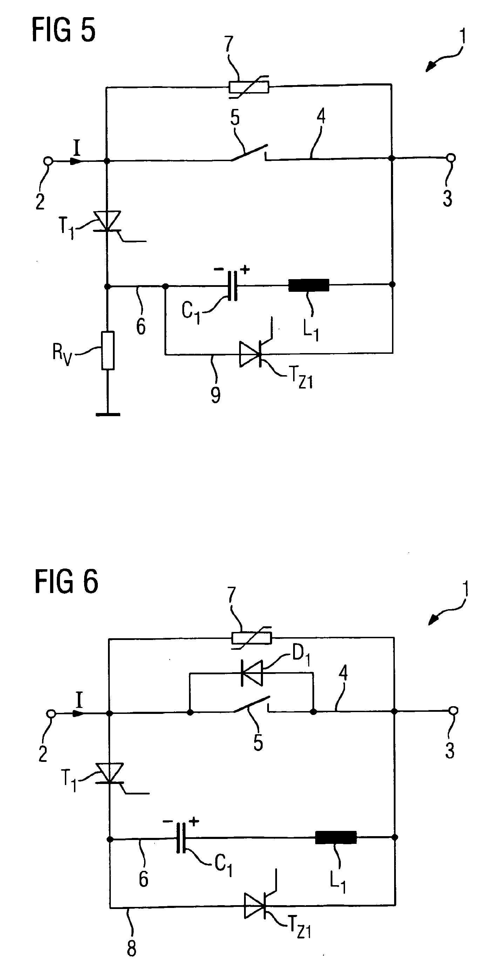

Figur 5 unterscheidet sich von dem in Figur 4 gezeigten Ausführungsbeispiel dadurch, dass ein ohmscher Ladungswiderstand R_{V} vorgesehen ist. Der Ladungswiderstand R_{V} ist auf der einen Seite mit dem Erdpotenzial und auf seiner vom Erdpotenzial abgewandten Seite mit dem Potenzialpunkt zwischen dem Thyristor T₁ und dem Kondensator C₁ verbunden. Die Aufladung des Kondensators C₁ vom Erdpotenzial aus ist mit einem sehr großen Aufwand verknüpft. Aus diesem Grunde wird erfindungsgemäß vorgeschlagen, den Kondensator C₁ durch das Gleichspannungsnetz aufzuladen. Dies wird mit Hilfe des Ladewiderstandes R_{V} ermöglicht. Der Wert des Ladewiderstandes R_{V} ist sehr groß zu wählen, um die Verluste und dessen Einfluss auf das Gleichspannungsnetz möglichst gering zu halten. Sinnvolle Werte für den Ladewiderstand R_{V} liegen zwischen R_{V} = 400 kΩ und R_{V} = 600 kΩ. Für die Vorladung des Kondensators C₁ auf diese Weise sind figürlich nicht dargestellte mechanische Trennschalter zweckmäßig, über die die Anschlussklemmen 2 beziehungsweise 3 jeweils mit dem Pol des Gleichspannungsnetzes verbunden sind. Beim Laden des Kondensators C₁ ist der mechanische Schalter 5 geschlossen.

Erst nach dem der Kondensator C₁ vollständig aufgeladen ist, kann die Vorrichtung 1 über die nicht gezeigten Trenner mit dem Pol der Gleichspannungsleitung verbunden werden, wobei sofort die Abschaltfähigkeit bereitgestellt ist.

Eine solche Vorladung über einen Ladewiderstand R_{V} kann selbstverständlich auch bei einer bidirektionalen Variante der erfindungsgemäßen Vorrichtung umgesetzt werden, wobei zwei Kondensatorzweige mit jeweils einem Kondensator und einem Pulsleistungshalbleiterschalter vorgesehen sind und wobei die Pulsleistungshalbleiterschalter gegensinnig zueinander orientiert und die Kondensatoren C₁ beziehungsweise C₂ entgegengesetzt zueinander polarisiert sind. Auf die bidirektionale Variante des Schalters wird später noch genauer eingegangen werden.

Wie bereits oben weiter diskutiert wurde, kann der mechanische Schalter 5 nach dem Löschen des Lichtbogens durch die Erzeugung eines Stromimpulses mit einer hohen transienten Wiederkehrspannung beaufschlagt werden. Diese transiente Wiederkehrspannung und vor allen Dingen die Anstiegsrate dieser Spannung können sehr große Werte annehmen. Diese transiente Wiederkehrspannung steht einer Wiederverfestigung der Isolationsstrecke im mechanischen Schalter entgegen und kann gegebenenfalls für eine Wiederzündung des Lichtbogens zwischen den Kontakten des mechanischen Schalters 5 sorgen. Um den mechanischen Schalter 5 während der Verfestigung seiner Isolationsstrecke zu entlasten, ist es zweckmäßig, dem mechanischen Schalter eine Diode, also eine Entlastungsdiode, parallel zu schalten. Eine solche Variante der Erfindung ist in Figur 6 gezeigt. Ganz allgemein ist jede Entlastungsdiode so orientiert, dass die transiente Wiederkehrspannung abgebaut werden kann, der Aufbau einer Gegenspannung jedoch ermöglicht ist. Aufgrund der in Figur 6 gezeigten Entlastungsdiode D₁ kann die Isolationsstrecke des mechanischen Schalters 5 sicher verfestigt werden und anschließend problemlos die erforderlichen Spannungen aufnehmen. Als mechanische Schalter 5 kommen beispielsweise eine Vakuumschaltröhre oder eine Reihenschaltung von Vakuumschaltröhren in Betracht. Selbstverständlich sind auch gasisolierte Schalter im Rahmen der Erfindung einsetzbar.

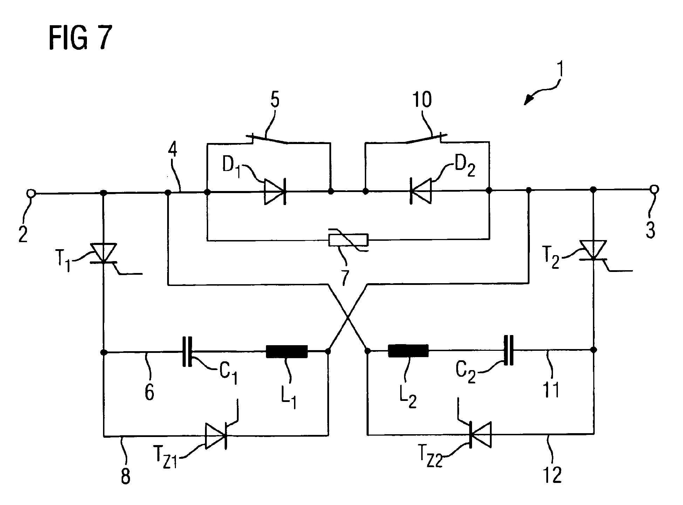

Figur 7 zeigt ein weiteres Ausführungsbeispiel der erfindungsgemäßen Vorrichtung 1, wobei eine bidirektionale Variante gezeigt ist. Bei der bidirektionalen Variante umfasst die erfindungsgemäßen Vorrichtung 1 einen zweiten mechanischen Schalter 10 in Reihe zum ersten mechanischen Schalter 5. Beiden mechanischen Schaltern 5, 10 ist wieder zur Vermeidung von transienten Wiederkehrspannungen eine Entlastungsdiode D₁ beziehungsweise D₂ parallel geschaltet. Der Reihenschaltung beider Schalter 5, 10 ist ein einziger Ableiter 7 parallel geschaltet. Zum Abschalten eines Stromes, der von der Anschlussklemme 3 zur Anschlussklemme 2 fließt, ist ein zweiter Kondensatorzweig 11 vorgesehen, in dem ein zweiter Kondensator C₂ sowie in Reihe dazu eine zweite Induktivität L2 angeordnet sind. Darüber hinaus ist ein zweiter Umpolungszweig L₂ erkennbar, in dem ein zweiter Umpolungsleistungshalbleiterschalter T_{Z2} angeordnet ist. Wie bereits eingangs erläutert wurde, kann auch in dem zweiten Umpolungszweig 12 in Reihe zum Umpolungsleistungshalbleiterschalter T_{Z2} eine Induktivität L_{Z2} sowie ein ohmscher Widerstand R_{Z2} angeordnet sein, die jedoch figürlich nicht dargestellt sind. Mit Hilfe dieser Ausgestaltung der erfindungsgemäßen Vorrichtung 1 können Ströme in beiden Richtungen sowohl geführt als auch abgeschaltet werden. Zum Laden des zweiten Kondensators C₂ wäre gegebenenfalls ein zweiter Vorladungswiderstand vorzusehen, der auf einer Seite mit dem Erdpotenzial oder mit dem anderen Pol des Gleichspannungsnetzes und auf seiner anderen Seite mit dem Potenzialpunkt zwischen dem Umpolungsleistungshalbleiterschalter T_{Z2} und dem Pulsleistungshalbleiterschalter T₂ verbunden ist.

## Patentansprüche

1. Vorrichtung (1) zum Schalten von Gleichströmen in einem Pol eines Gleichspannungsnetzes mit
- zwei Anschlussklemmen (2,3) zum seriellen Einbinden der Vorrichtung (1) in den Pol,
- einem sich zwischen den Anschlussklemmen (2,3) erstreckenden Betriebsstrompfad (4), in dem ein mechanischer Schalter (5) angeordnet ist,
- einem den mechanischen Schalter (5) überbrückenden Kondensatorzweig (6), in dem ein Kondensator C₁ angeordnet ist, und
- einem in Reihe zum Kondensator C₁ angeordneten Pulsleistungshalbleiterschalter T₁ zur Entladung des Kondensators C₁, so dass in einer aus Betriebsstrompfad (4) und Kondensatorzweig (6) gebildeten Masche ein dem Betriebsstrom I im mechanischen Schalter (5) entgegen gerichteter Impulskreisstrom fließt,
**dadurch gekennzeichnet, dass** ein den Kondensator C₁ überbrückender Umpolungszweig (9) vorgesehen ist, in dem ein ansteuerbarer Umpolungsleistungshalbleiterschalter T_{Z1} angeordnet ist.

2. Vorrichtung (1) nach Anspruch 1,
**dadurch gekennzeichnet, dass** in dem Kondensatorzweig (6) eine erste Induktivität L₁ angeordnet ist.

3. Vorrichtung (1) nach einem der vorhergehenden Ansprüche,
**dadurch gekennzeichnet, dass** in dem Umpolungszweig (6) eine zweite Induktivität L_{Z1} in Reihe zum Umpolungsleistungshalbleiterschalter T_{Z1} angeordnet ist.

4. Vorrichtung (1) nach einem der vorhergehenden Ansprüche,
**dadurch gekennzeichnet, dass** in dem Umpolungszweig (9) ein ohmscher Widerstand R_{Z1} angeordnet ist.

5. Vorrichtung (1) nach einem der vorhergehenden Ansprüche,
**dadurch gekennzeichnet, dass** der Kondensatorzweig (6) über einen Ladungswiderstand R_{V} mit dem Erdpotenzial oder einem anderen Pol des Gleichspannungsnetzes verbindbar ist.

6. Vorrichtung (1) nach einem der vorhergehenden Ansprüche,
**dadurch gekennzeichnet, dass** ein zweiter Kondensatorzweig (11) mit einem zweiten Kondensator C₂ und einem zweiten Pulsleistungshalbleiterschalter T_{Z} vorgesehen sind, wobei ein zweiter Umpolungszweig (12) mit einem zweiten Umpolleistungshalbleiterschalter T_{Z2} vorgesehen ist.

7. Vorrichtung (1) nach einem der vorhergehenden Ansprüche,
**dadurch gekennzeichnet, dass** jedem mechanischen Schalter (5) des Betriebsstrompfades (4) eine Entlastungsdiode D₁ parallel geschaltet ist.

## Claims

1. Apparatus (1) for switching direct currents in a pole of a DC voltage system, comprising
- two connection terminals (2, 3) for incorporating the apparatus (1) into the pole in series,
- an operating current path (4) which extends between the connection terminals (2, 3) and in which a mechanical switch (5) is arranged,
- a capacitor branch (6) which bridges the mechanical switch (5) and in which a capacitor C₁ is arranged, and
- a pulse-controlled power semiconductor switch T₁, which is arranged in series with the capacitor C₁, for discharging the capacitor C₁, so that a pulse circulating current which is directed in the opposite direction to the operating current I in the mechanical switch (5) flows in a mesh which is formed from the operating current path (4) and the capacitor branch (6),
**characterized in that**
a polarity-reversal branch (9) which bridges the capacitor C₁ is provided, a polarity-reversal power semiconductor switch T_{Z1} which can be driven being arranged in the said polarity-reversal branch.

2. Apparatus (1) according to Claim 1,
**characterized in that**
a first inductance L₁ is arranged in the capacitor branch (6).

3. Apparatus (1) according to either of the preceding claims,
**characterized in that**
a second inductance L_{Z1} is arranged in series with the polarity-reversal power semiconductor switch T_{Z1} in the polarity-reversal branch (6).

4. Apparatus (1) according to one of the preceding claims, **characterized in that**
a non-reactive resistor R_{Z1} is arranged in the polarity-reversal branch (9).

5. Apparatus (1) according to one of the preceding claims,
**characterized in that**
the capacitor branch (6) can be connected to earth potential or to another pole of the DC voltage system via a charging resistor R_{V}.

6. Apparatus (1) according to one of the preceding claims,
**characterized in that**
a second capacitor branch (11) comprising a second capacitor C₂ and a second pulse-controlled power semiconductor switch T_{Z} is provided, wherein a second polarity-reversal branch (12) comprising a second polarity-reversal power semiconductor switch T_{Z2} is provided.

7. Apparatus (1) according to one of the preceding claims,
**characterized in that**
a load-relief diode D₁ is connected in parallel with each mechanical switch (5) of the operating current path (4).

## Revendications

1. Dispositif (1) pour appliquer des courants continus à un pôle d'un réseau de tension continue, comprenant
- deux bornes ( 2, 3 ) de connexion pour l'intégration en série du dispositif ( 1 ) au pôle,
- un trajet ( 4 ) de courant de fonctionnement qui s'étend entre les deux bornes ( 2, 3 ) de connexion et dans lequel est monté un interrupteur ( 5 ) mécanique,
- une branche ( 6 ) de condensateur qui court-circuite l'interrupteur ( 5 ) mécanique et dans lequel est monté un condensateur C₁, et
- un interrupteur T₁ à semiconducteur de puissance à impulsion, monté en série avec le condensateur C₁, pour décharger le condensateur C₁ de manière à faire passer, dans une maille formée du trajet ( 4 ) de courant de fonctionnement et de la branche ( 6 ) de condensateur, un courant circulaire à impulsion, dirigé en sens contraire du courant I de fonctionnement dans l'interrupteur ( 5 ) mécanique,
**caractérisé en ce qu'**il est prévu une branche ( 9 ) d'inversion des polarités qui court-circuite le condensateur C₁ et dans laquelle est monté un interrupteur T_{Z1} à semiconducteur de puissance d'inversion des polarités, qui peut être commandée.

2. Dispositif ( 1 ) suivant la revendication 1,
**caractérisé en ce que**
une première inductance L₁ est montée dans la branche ( 6 ) de condensateur.

3. Dispositif ( 1 ) suivant l'une des revendications précédentes,
**caractérisé en ce que**
dans la branche ( 6 ) d'inversion des polarités, une deuxième inductance Lz₁ est montée en série avec l'interrupteur T_{z1} à semiconducteur de puissance d'inversion des polarités.

4. Dispositif (1) suivant l'une des revendications précédentes,
**caractérisé en ce que**
une résistance Rz₁ ohmique est montée dans la branche ( 9 ) d'inversion des polarités.

5. Dispositif (1) suivant l'une des revendications précédentes,
**caractérisé en ce que**
la branche ( 6 ) de condensateur peut être reliée par l'intermédiaire d'une résistance Rᵥ de charge au potentiel de terre ou à un autre pôle du réseau de tension continue.

6. Dispositif (1) suivant l'une des revendications précédentes,
**caractérisé en ce que**
il est prévu une deuxième branche ( 11 ) de condensateur ayant un deuxième condensateur C₂ et un deuxième interrupteur T₂ à semiconducteur de puissance à impulsion, une deuxième branche ( 12 ) d'inversion des polarités ayant un deuxième interrupteur T_{z2} à semiconducteur de puissance d'inversion des polarités étant prévue.

7. Dispositif (1) suivant l'une des revendications précédentes,
**caractérisé en ce que**
une diode D₁ de décharge est montée en parallèle à chaque interrupteur ( 5 ) mécanique du trajet ( 4 ) de courant de fonctionnement.
